# EUROPEAN PATENT APPLICATION

(11) **EP 3 276 672 A1**
(43) Date of publication of application: **31.01.2018**
(21) Application number: 16768807.6
(22) Date of filing: 23.03.2016
(51) Int. Cl.: H01L 31/042, H01L 31/05, H01L 31/054, H02S 40/34

(54) **FLEXIBLE PRINTED CIRCUIT JOINING STRUCTURE, CONCENTRATOR PHOTOVOLTAIC MODULE, AND FLEXIBLE PRINTED CIRCUIT JOINING METHOD**

(30) Priority: 24.03.2015 JP 2015060625
(71) Applicant: Sumitomo Electric Industries, Ltd., Osaka-shi, Osaka 541-0041 (JP)
(72) Inventor: NAGAI, Youichi, Osaka-shi Osaka 554-0024 (JP); IWASAKI, Takashi, Osaka-shi Osaka 554-0024 (JP); ABIKO, Yoshiya, Osaka-shi Osaka 554-0024 (JP); TOYA, Kazumasa, Osaka-shi Osaka 554-0024 (JP); SAITO, Kenji, Osaka-shi Osaka 554-0024 (JP)
(74) Representative: Boult Wade Tennant
(86) International application number: PCT/JP2016/059155
(87) International publication number: WO 2016/152904

(57) **Abstract**

The joint structure includes: a junction box configured to connect an internal circuit of an apparatus and an external conductor to each other; a metal electrode being in the junction box and to be joined to the external conductor; and a flexible printed circuit in a strip shape, the flexible printed circuit forming the internal circuit and having an end portion to be joined to the metal electrode. The metal electrode has a joint portion to be joined to the end portion in a superposed manner, and the joint portion in a free and lone state before being superposed on the end portion is ensured to have a gap greater than the thickness of the end portion (including solder), between the joint portion and its opposed surface, and has movability toward the opposed surface side when the joint portion is pressed.

## Description

### TECHNICAL FIELD

The present invention relates to a joint structure and a joining method for a flexible printed circuit, and relates to a concentrator photovoltaic module including such a joint structure, for example.

### BACKGROUND ART

Concentrator photovoltaic (CPV) is based on a structure in which sunlight concentrated by a lens is caused to be incident on a power generating element (solar cell) composed of a small-sized compound semiconductor having a high power generating efficiency. One module can be formed by disposing a large number of such basic structures vertically and horizontally. As a substrate for power generating elements to be disposed over a wide area, a long substrate has been proposed in which power generating elements are mounted at equal intervals, for example (see FIG. 5 of PATENT LITERATURE 1, for example). In this case, two adjacent long substrates are connected to each other by means of a wiring coupling material.

As such a long substrate, a flexible printed circuit (FPC) can be used (see PATENT LITERATURE 2).

The output from power generating elements is taken out of a module through in-module circuit connection, for example, in which a certain number of power generating elements are connected to each other in series on the substrate or in which such series-connected power generating elements are further connected to each other in parallel. In order to finally take the output from the substrate in the module to outside, it is necessary to connect the substrate to a connector provided to the housing of the module, for example. For providing such connection, a cable is used (see FIG. 6 of PATENT LITERATURE 3, for example), or a special connector which couples the substrate and the housing together is used (see FIG. 1 of PATENT LITERATURE 3, for example).

### CITATION LIST

### [PATENT LITERATURE]

PATENT LITERATURE 1: Japanese Patent No. 5214005
PATENT LITERATURE 2: Japanese Laid-Open Patent Publication No. 2013-80760
PATENT LITERATURE 3: Japanese Laid-Open Patent Publication No. 2013-145707

### SUMMARY OF INVENTION

### [TECHNICAL PROBLEM]

However, if a cable is used to provide connection in the module, it takes time in the connection step. On the other hand, if a special connector is used, the required time for the connection step may be reduced but the product cost is increased. In either case, automation of the connection step is difficult.

In view of the conventional problems, an object of the present invention is, on the precondition that a flexible printed circuit is used in an apparatus, to provide a joint structure/joining method which realize easy and reliable work in connecting the end portion of the flexible printed circuit to the external conductor and which are also preferable to realize automation of work.

### [SOLUTION TO PROBLEM]

### <Flexible-printed-circuit joint structure>

A flexible-printed-circuit joint structure according to the present invention includes: a junction box configured to connect an internal circuit of an apparatus and an external conductor to each other; a metal electrode being in the junction box and to be joined to the external conductor; and a flexible printed circuit in a strip shape, the flexible printed circuit forming the internal circuit and having an end portion to be joined to the metal electrode. In the flexible-printed-circuit joint structure, the metal electrode has a joint portion to be joined to the end portion in a superposed manner, and the joint portion in a free and lone state before being superposed on the end portion is ensured to have a gap greater than a thickness of the end portion, between the joint portion and a surface opposed to the joint portion, and has movability toward the opposed surface side when the joint portion is pressed.

### <Concentrator photovoltaic module>

A concentrator photovoltaic module according to the present invention includes: a concentrating portion in which condenser lenses each converging sunlight are arranged in a matrix shape; a housing configured to support the concentrating portion; a flexible printed circuit arranged on a bottom surface of the housing; power generating elements arranged on the flexible printed circuit so as to correspond to light-concentrating positions of the respective condenser lenses; a junction box formed in a part of the bottom surface of the housing so as to be recessed relative to the bottom surface, the junction box having connected thereto an external conductor for collecting outputs of the power generating elements and for providing the collected outputs to outside; a metal electrode being in the junction box and to be joined to the external conductor; and a flexible printed circuit in a strip shape, the flexible printed circuit forming an internal circuit and having an end portion to be joined to the metal electrode. In the concentrator photovoltaic module, the metal electrode has a joint portion to be joined to the end portion in a superposed manner, and the joint portion in a free and lone state before being superposed on the end portion is ensured to have a gap greater than a thickness of the end portion, between the joint portion and a surface opposed to the joint portion, and has movability toward the opposed surface side when the joint portion is pressed.

### <Flexible-printed-circuit joining method>

A flexible-printed-circuit joining method according to the present invention is a method in which, in a junction box for connecting an internal circuit of an apparatus and an external conductor to each other, a metal electrode to be joined to the external conductor is connected to an end portion of a strip-shaped flexible printed circuit forming the internal circuit, the method including: establishing a state in which a joint portion, of the metal electrode, to be joined to the end portion in a superposed manner is ensured to have a predetermined gap in a free and lone state of the joint portion, between the joint portion and a surface opposed to the joint portion, and has movability toward the opposed surface side when the joint portion is pressed; inserting into the gap the end portion having a smaller thickness than a dimension of the gap; and joining the joint portion and the end portion to each other by performing local heating thereon in a state where the joint portion and the end portion are closely attached to each other with a welder electrode pressed against the joint portion.

### [ADVANTAGEOUS EFFECTS OF INVENTION]

According to the present invention, the work in connecting the end portion of the flexible printed circuit to the external conductor becomes easy and reliable, which is also preferable for automation of work.

### BRIEF DESCRIPTION OF DRAWINGS

FIG. 1 is a perspective view showing one example of a concentrator photovoltaic apparatus;
FIG. 2 is a perspective view (partially cut out) showing an enlarged view of one example of the concentrator photovoltaic module;
FIG. 3 is a plan view showing in more detail the bottom surface of a housing shown in FIG. 2;
FIG. 4 shows the rear surface of the housing;
FIG. 5 is a perspective view showing a junction box in its completed state in a flexible-printed-circuit joint structure (joining method) according to a first embodiment;
FIG. 6 is an exploded perspective view showing a part of the junction box shown in FIG. 5;
FIG. 7 is a perspective view showing a (first) step of joining an end portion of the flexible printed circuit to a metal electrode;
FIG. 8 is a perspective view showing a (second) step of joining the end portion of the flexible printed circuit to the metal electrode;
FIG. 9 is a perspective view showing a step (completed state) of joining the end portion of the flexible printed circuit to the metal electrode;
FIG. 10 is a perspective view showing the junction box in its completed state in the flexible-printed-circuit joint structure (joining method) according to a second embodiment;
FIG. 11 is an exploded perspective view showing a part of the junction box shown in FIG. 10;
FIG. 12 shows cross-sectional views showing steps ((a) shows the first step, and (b) shows the second step) of joining the end portion of the flexible printed circuit to the metal electrode in the second embodiment;
FIG. 13 is a cross-sectional view showing a step (completed state) of joining the end portion of the flexible printed circuit to the metal electrode in the second embodiment; and
FIG. 14 shows cross-sectional views illustrating the outline of welding performed by two types of welders, in which (a) shows a pulse heat welder and (b) shows a resistance welder.

### DESCRIPTION OF EMBODIMENTS

### [Summary of embodiment]

The summary of embodiments of the present invention includes at least the following.
(1) A flexible-printed-circuit joint structure includes: a junction box configured to connect an internal circuit of an apparatus and an external conductor to each other; a metal electrode being in the junction box and to be joined to the external conductor; and a flexible printed circuit in a strip shape, the flexible printed circuit forming the internal circuit and having an end portion to be joined to the metal electrode. In the flexible-printed-circuit joint structure, the metal electrode has a joint portion to be joined to the end portion in a superposed manner, and the joint portion in a free and lone state before being superposed on the end portion is ensured to have a gap greater than a thickness of the end portion, between the joint portion and a surface opposed to the joint portion, and has movability toward the opposed surface side when the joint portion is pressed.
   In this flexible-printed-circuit joint structure, the joint portion of the metal electrode in a free and lone state before being joined to the end portion is ensured to have a gap greater than the thickness of the end portion, between the joint portion and its opposed surface. Thanks to the presence of this gap, without raising the joint portion of the metal electrode, it is possible to easily insert the end portion of the flexible printed circuit, between the joint portion and its opposed surface. Thus, according to this joint structure, members for providing the joining can be easily and reliably arranged, and further, through the welding step, the joint portion and the end portion can be easily and quickly joined together. That is, the work in connecting the end portion of the flexible printed circuit to the external conductor becomes easy and reliable, which is also preferable to realize automation of work.
(2) In the joint structure according to (1), the joint portion may be formed from a part of the metal electrode so as to have the gap, with a base portion except the part of the metal electrode assumed as the opposed surface.
   In this case, the joint portion can be formed in a simple manner through work in slightly raising and bending a part of the metal electrode, for example, thereby ensuring the necessary gap.
(3) In the joint structure according to (2), the joint portion may have elasticity that allows the joint portion to come close to the opposed surface.
   In this case, a joint structure can be realized in which, for example, when a welder electrode is pressed against the joint portion, the joint portion flexes to be closely attached to the end portion in a reliable manner.
(4) The joint structure according to (1) may be configured such that a pair of the joint portions is provided in the metal electrode, a pair of the flexible printed circuits is present, and end portions of the pair of the flexible printed circuits are respectively joined to the pair of the joint portions.
   In this case, two end portions are inserted to be joined to their corresponding joint portions, respectively. Thus, for example, two circuits in parallel can be connected to the external conductor in the single junction box.
(5) The joint structure according to (4) may be configured such that the junction box has a protrusion formed therein, the metal electrode is engaged with the protrusion by means of a recess formed in a center portion of the metal electrode, and the end portions of the pair of the flexible printed circuits face the protrusion from opposite sides of the protrusion.
   The protrusion in this case is helpful in positioning the metal electrode and positioning the end portions of the pair of the flexible printed circuits.
(6) The joint structure according to (5) may be configured such that each joint portion in a free and lone state before being superposed on the end portion corresponding thereto is ensured to have the gap between the joint portion and the opposed surface, due to the engagement with the protrusion.
   In this case, without employing a special shape of the metal electrode, it is possible to ensure the gap for inserting the end portion by use of the engagement with the protrusion.
(7) In the joint structure according to any one of (1) to (6), preferably, the junction box is provided on a bottom surface of the apparatus and is formed so as to be recessed relative to the bottom surface.
   In this case, it is easy to flow an insulating material such as silicone resin into the junction box after completion of the joining. The junction box in this case is realized as an insulating-material molded frame.
(8) Meanwhile, a concentrator photovoltaic module includes: a concentrating portion in which condenser lenses each converging sunlight are arranged in a matrix shape; a housing configured to support the concentrating portion; a flexible printed circuit arranged on a bottom surface of the housing; power generating elements arranged on the flexible printed circuit so as to correspond to light-concentrating positions of the respective condenser lenses; a junction box formed in a part of the bottom surface of the housing so as to be recessed relative to the bottom surface, the junction box having connected thereto an external conductor for collecting outputs of the power generating elements and for providing the collected outputs to outside; a metal electrode being in the junction box and to be joined to the external conductor; and a flexible printed circuit in a strip shape, the flexible printed circuit forming an internal circuit and having an end portion to be joined to the metal electrode. In the concentrator photovoltaic module, the metal electrode has a joint portion to be joined to the end portion in a superposed manner, and the joint portion in a free and lone state before being superposed on the end portion is ensured to have a gap greater than a thickness of the end portion, between the joint portion and a surface opposed to the joint portion, and has movability toward the opposed surface side when the joint portion is pressed.
   In this concentrator photovoltaic module, the joint portion of the metal electrode in a free and lone state before being joined to the end portion is ensured to have a gap greater than the thickness of the end portion, between the joint portion and its opposed surface. Thanks to the presence of this gap, without raising the joint portion of the metal electrode, it is possible to easily insert the end portion of the flexible printed circuit, between the joint portion and its opposed surface. Thus, in the concentrator photovoltaic module having such a joint structure, members for providing the joining can be easily and reliably arranged, and further, through the welding step, the joint portion and the end portion can be easily and quickly joined together. That is, the work in connecting the end portion of the flexible printed circuit to the external conductor becomes easy and reliable, which is also preferable to realize automation of work.
(9) In the concentrator photovoltaic module according to (8), preferably, the flexible printed circuit is arranged so as to seamlessly continue on the bottom surface.
   In this case, since there is no connected portion of the flexible printed circuit on the bottom surface, high reliability in electric connection is realized.
(10) A flexible-printed-circuit joining method according to the present invention is a method in which, in a junction box for connecting an internal circuit of an apparatus and an external conductor to each other, a metal electrode to be joined to the external conductor is connected to an end portion of a strip-shaped flexible printed circuit forming the internal circuit, the method including: establishing a state in which a joint portion, of the metal electrode, to be joined to the end portion in a superposed manner is ensured to have a predetermined gap in a free and lone state of the joint portion, between the joint portion and a surface opposed to the joint portion, and has movability toward the opposed surface side when the joint portion is pressed; inserting into the gap the end portion having a smaller thickness than a dimension of the gap; and joining the joint portion and the end portion to each other by performing local heating thereon in a state where the joint portion and the end portion are closely attached to each other with a welder electrode pressed against the joint portion.

In this flexible-printed-circuit joining method, the joint portion of the metal electrode in a free and lone state before being joined to the end portion is ensured to have a gap greater than the thickness of the end portion, between the joint portion and its opposed surface. Thanks to the presence of this gap, without raising the joint portion of the metal electrode, it is possible to easily insert the end portion of the flexible printed circuit, between the joint portion and its opposed surface. Thus according to this method, through welding (pulse welding or resistance welding), the joint portion and the end portion can be easily and quickly joined together. That is, the work in connecting the end portion of the flexible printed circuit to the external conductor becomes easy and reliable, which is also preferable to realize automation of work.

### [Details of embodiments]

### «One example of apparatus that employs flexible-printed-circuit joint structure/joining method»

Hereinafter, details of embodiments of the present invention will be described with reference to the drawings. First, description will be given of a configuration of a concentrator photovoltaic apparatus when assuming a concentrator photovoltaic module as one example that employs the flexible-printed-circuit joint structure/joining method being one embodiment of the present invention.

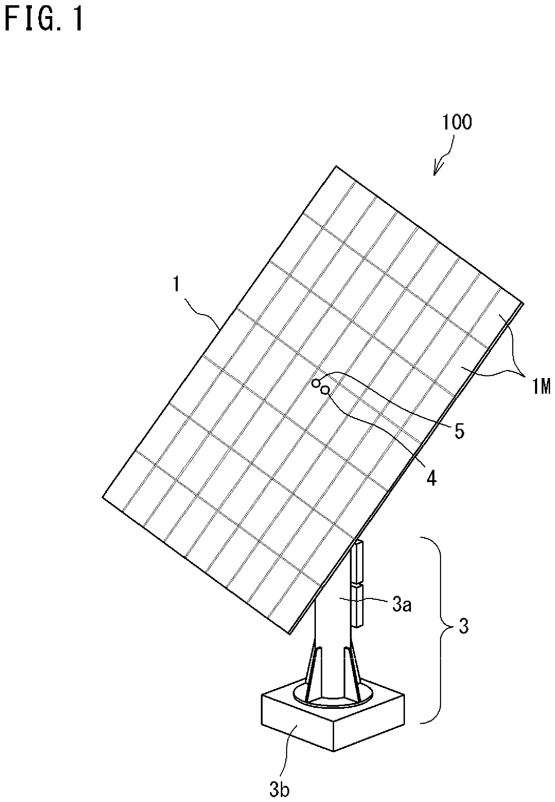

FIG. 1 is a perspective view showing one example of a concentrator photovoltaic apparatus. In FIG. 1, a concentrator photovoltaic apparatus 100 includes a concentrator photovoltaic panel 1, and a pedestal 3 which includes a post 3a and a base 3b thereof, the post 3a supporting the concentrator photovoltaic panel 1 on the rear surface thereof. The concentrator photovoltaic panel 1 is formed by assembling a large number of concentrator photovoltaic modules 1M vertically and horizontally. In this example, 62 (7 in length × 9 in breadth - 1) concentrator photovoltaic modules 1M are assembled vertically and horizontally, except the center portion. When one concentrator photovoltaic module 1M has a rated output of, for example, about 100 W, the entirety of the concentrator photovoltaic panel 1 has a rated output of about 6 kW.

On the rear surface side of the concentrator photovoltaic panel 1, a driving deice (not shown) is provided, and by operating this driving deice, it is possible to drive the concentrator photovoltaic panel 1 in two axes of the azimuth and the elevation. Accordingly, the concentrator photovoltaic panel 1 is driven so as to always face the direction of the sun in both of the azimuth and the elevation, by use of stepping motors (not shown). In addition, for example, at a place (in this example, the center portion) on the concentrator photovoltaic panel 1, or in the vicinity of the panel 1, a tracking sensor 4 and a pyrheliometer 5 are provided. Operation of tracking the sun is performed, relying on the tracking sensor 4 and the position of the sun calculated from the time, the latitude, and the longitude of the installation place.

That is, every time the sun has moved by a predetermined angle, the driving deice drives the concentrator photovoltaic panel 1 by the predetermined angle. The event that the sun has moved by the predetermined angle may be determined by the tracking sensor 4, or may be determined by the latitude, the longitude, and the time. Thus, there are also cases that the tracking sensor 4 is omitted. The predetermined angle is, for example, a constant value, but the value may be changed in accordance with the altitude of the sun and the time. Moreover, use of the stepping motors is one example, and other than this, a drive source capable of performing precise operation may be used.

### «One example of concentrator photovoltaic module»

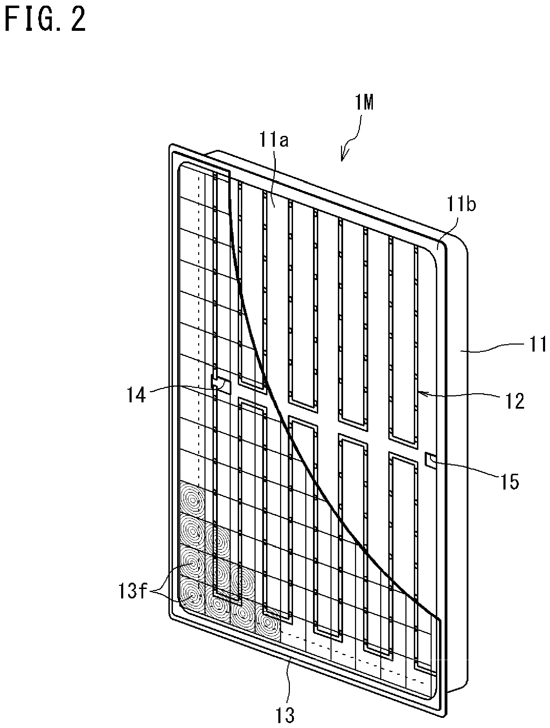

FIG. 2 is a perspective view (partially cut out) showing an enlarged view of one example of the concentrator photovoltaic module (hereinafter, also simply referred to as module) 1M. In FIG. 2, the module 1M includes, as main components, a housing 11 formed in a rectangular vessel shape and having a bottom surface 11a, flexible printed circuits 12 provided in contact with the bottom surface 11a, and a primary concentrating portion 13 attached, like a cover, to a flange portion 11b of the housing 11. The housing 11 is made of metal. The output ends of each flexible printed circuit 12 are separated at the positive side and the negative side, and are respectively drawn into junction boxes 14 and 15 provided on the rear surface of the housing 11 so as to project therefrom.

The primary concentrating portion 13 is a Fresnel lens array and is formed by arranging, in a matrix shape, a plurality of (for example, 14 in length × 10 in breadth, 140 in total) Fresnel lenses 13f as lens elements which concentrate sunlight. The primary concentrating portion 13 can be obtained by, for example, forming a silicone resin film on a back surface (inside) of a glass plate as a base material. Each Fresnel lens is formed on this resin film.

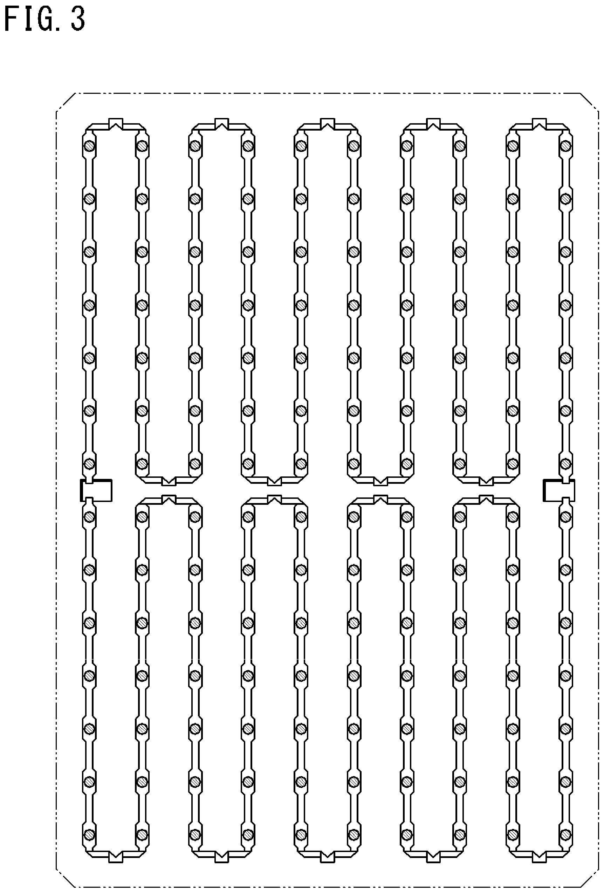

FIG. 3 is a plan view showing in more detail the bottom surface 11a of the housing 11 shown in FIG. 2. This shows the shape and arrangement of the flexible printed circuits 12 as one example. Of course, since the flexible printed circuits 12 can be shaped and arranged in various ways, this is merely one example.

On each flexible printed circuit 12, a large number of power generating elements (solar cells) 16 are arranged at equal intervals. Each power generating element 16 is on the optical axis of its corresponding Fresnel lens 13f, the optical axis obtained when sunlight is incident on the Fresnel lens 13f at an incident angle of 0 degree. Light converged by the Fresnel lens 13f is incident on its corresponding power generating element 16. In some cases, each power generating element 16 has disposed thereon a spherical lens or the like as a secondary concentrating portion, for example, but the detail thereof is not described here.

Although not shown, on each flexible printed circuit 12, a copper pattern or a bypass diode connecting power generating elements 16 are provided. The flexible printed circuit 12 of the present example has a greater width at portions where power generating elements 16 are mounted, and has a smaller width at the other portions. In each of the upper part and the lower part of FIG. 3, the flexible printed circuit 12 is formed in one piece, and thus arranged so as to seamlessly continue. Since there is no connected portion on the bottom surface 11a, high reliability in electric connection is realized. If the vertical direction in the drawing is defined as a row, the portion connecting adjacent two rows to each other is thinner than the portion where power generating elements 16 are provided, and is slightly raised from the bottom surface 11a by utilizing the thinness of the portion, and thus, not necessarily closely attached to the bottom surface 11a.

For example, with respect to the upper half of FIG. 3, power generating elements 16 are connected in series, and of the ends (the end on the positive side and the end on the negative side) of the flexible printed circuit 12, the positive side end is drawn into the junction box 14, and the negative side end is drawn into the junction box 15, for example. This applies also to the lower half of FIG. 3. Thus, in this example, the output from a series circuit on the upper side having 70 power generating elements 16 thereon and the output from a series circuit on the lower side having 70 power generating elements 16 thereon are in parallel with each other. The end connection and parallel connection are established in the junction box 14 and 15.

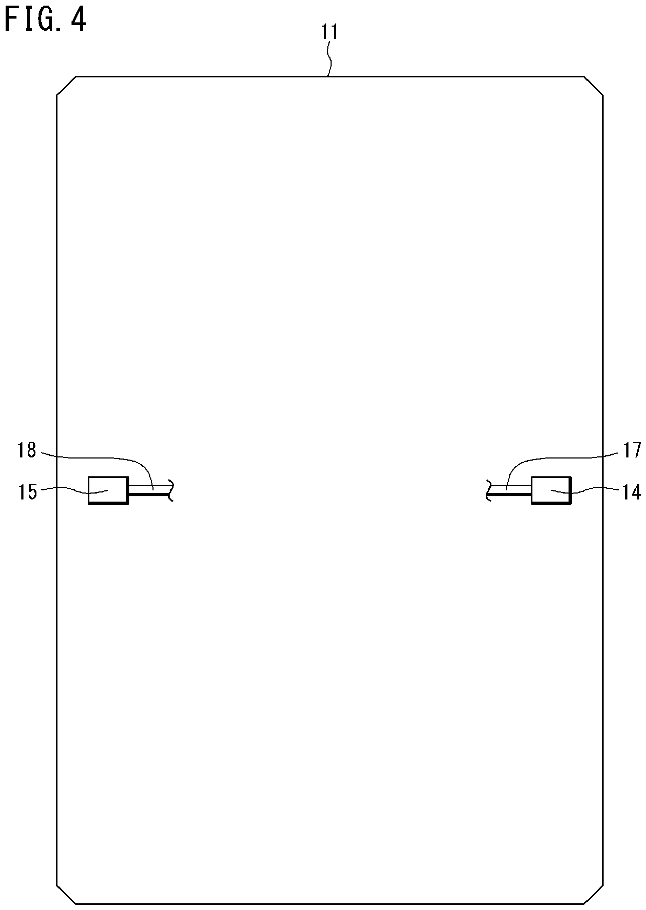

FIG. 4 shows the rear surface of the housing 11. As described above, the junction boxes 14 and 15 project on the rear surface side, and respectively have output cables 17 and 18 as "external conductors" connected thereto. As the external conductor, a cable is used in general, but an insulated bar may be used.

### «First embodiment of joint structure/joining method»

Next, a first embodiment as the flexible-printed-circuit joint structure/joining method will be described.

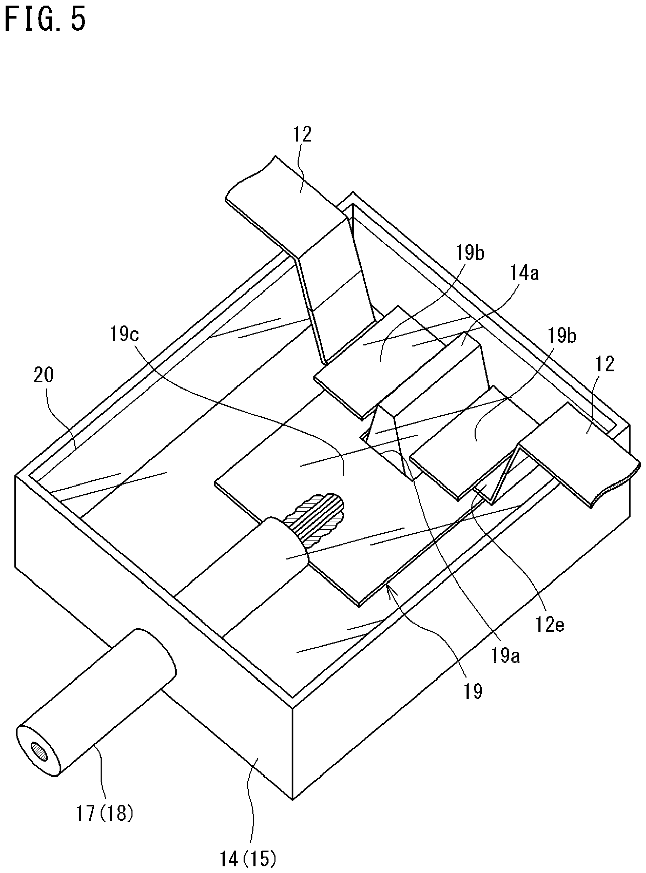

FIG. 5 is a perspective view showing the junction box 14 in its completed state. This junction box 14 is illustrated in a rectangular parallelepiped shape without a top face, but this is merely one example, and actually, the junction box 14 can be formed in various shapes as necessary. FIG. 5 merely shows one of the simplest shapes, here. The junction box 14 is fixed to the bottom surface 11a of the housing 11, at a predetermined position (FIG. 4) on the rear surface side thereof. The other junction box 15 has the same structure, and thus, the junction box 14 will be described in detail as a representative example.

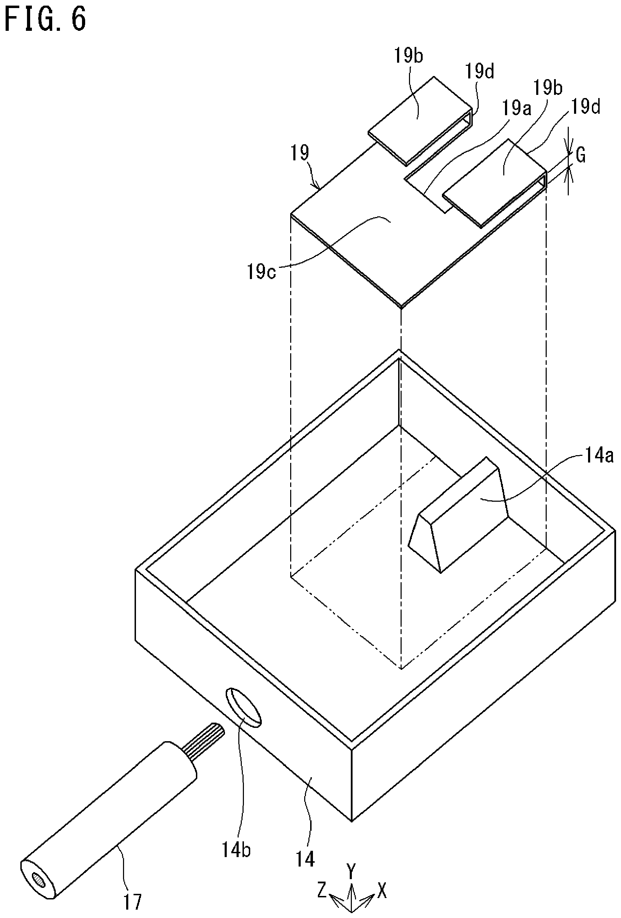

FIG. 6 is an exploded perspective view showing a part of the junction box 14 shown in FIG. 5.

In FIG. 6, the junction box 14 is a molded article made of heat resistant resin, for example. On the bottom surface of the junction box 14, a protrusion 14a for positioning is formed. For example, the width of the protrusion 14a in the Z direction in the drawing is decreased in accordance with increase in the height thereof in the Y direction (height direction) so as to facilitate mounting of a metal electrode 19. A hole 14b is formed in one side surface of the junction box 14, and the cable 17 can be passed through the hole 14b.

A recess 19a having a shape corresponding to the protrusion 14a is formed in the metal electrode 19 being an electric conductor (copper plate, for example). That is, while avoiding bumping into the protrusion 14a by means of the recess 19a, the metal electrode 19 can be guided to the protrusion 14a to be engaged therewith. On both sides of the recess 19a, a pair of joint portions 19b is formed. As shown in FIG. 6, each joint portion 19b is formed by slightly raising a leading end portion of a base portion 19c of the metal electrode 19 (to form a raised portion 19d) to be bent in the -X direction. This forming method can be realized in a simple manner by bending work, and thus, is suitable for production.

However, the method forming the metal electrode 19 as shown in FIG. 6 is not limited thereto. For example, instead of forming the raised portion 19d, the joint portion 19b may be fixed as a part of the metal electrode, via a metal spacer which ensures a gap G. That is, it is sufficient that the joint portion 19b as a part of the metal electrode 19 (the part may not necessarily be the same metal electrode 19) is formed so as to have the gap G, with the base portion 19c except the part assumed as a surface opposed to the joint portion 19b. The joint portion 19b has movability in the Y direction (accurately, in -Y direction) in the drawing when the joint portion 19b is pressed in the Y direction.

With reference back to FIG. 5, the cable 17 is soldered to the metal electrode 19, for example. An end portion 12e of each flexible printed circuit 12 is disposed under its corresponding joint portion 19b, to be electrically and physically joined to the joint portion 19b. After completion of the joining, the junction box 14 is filled with silicone resin 20, for example. The silicone resin 20 insulates and protects the metal electrode 19, the end portion 12e of each flexible printed circuit 12, and the mutual joining site of the cable 17, and fixes the entirety thereof. Since the junction box 14 is formed so as to be recessed relative to the bottom surface 11a of the housing 11, it is easy to flow the silicone resin into the junction box 14 after completion of the joining. That is, the junction box 14 is realized as a silicone resin molded frame.

Now, the method for joining the joint portion 19b and the end portion 12e of the flexible printed circuit 12 will be described.

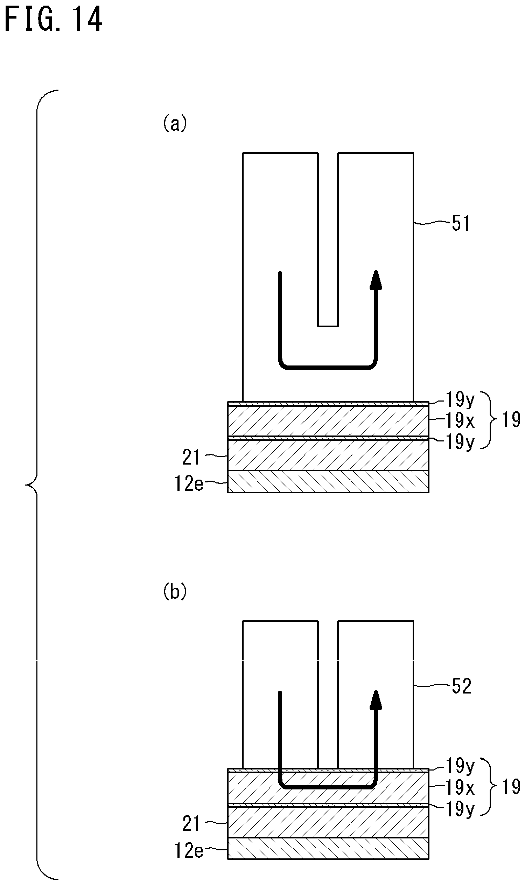

FIG. 14 shows cross-sectional views illustrating the outline of welding performed by two types of welders. First, shown in (a) of FIG. 14 is a pulse heat welder. A welder electrode 51 is in a U-shape as shown. The metal electrode 19 (copper foil 19x and Sn plated layer 19y) is disposed under the welder electrode 51, and the end portion 12e having solder 21 thereon is disposed under the metal electrode 19.

In this case, when a current as indicated by the arrow shown in FIG. 14 is caused to flow in the welder electrode 51, the welder electrode 51 generates heat, and the heat is conveyed to the solder 21 via the metal electrode 19. As a result, the solder 21 (melting point: 220 to 225°C) and the Sn plated layer 19y (melting point: about 230°C) in contact therewith melt to be welded to each other.

Thus, the pulse heat welder causes the heat generated when the current is caused to flow in the welder electrode 51, to be conducted to the solder 21 via the metal electrode 19, thereby realizing weld joining.

Meanwhile, (b) of FIG. 14 shows a resistance welder. A welder electrode 52 is composed of two electrodes as shown. The metal electrode 19 (copper foil 19x and Sn plated layer 19y) is disposed under the welder electrode 52, and the end portion 12e having the solder 21 thereon is disposed under the metal electrode 19.

In this case, when the current as indicated by the arrow as shown is caused to flow in the welder electrode 52, heat is generated due to resistance between the welder electrode 52 and the Sn plated layer 19y. This generated heat is conveyed to the solder 21 via the metal electrode 19. As a result, the solder 21 and the Sn plated layer 19y in contact therewith melt to be welded to each other.

Thus, the resistance welder causes the heat generated when the current is caused to flow from the welder electrode 52 to the metal electrode 19, to be conducted to the solder 21 via the metal electrode 19, thereby realizing weld joining.

Either the pulse heat welding or the resistance welding described above can realize easy and quick welding by local heating. Therefore, the work in joining the end portion 12e of the flexible printed circuit 12 to the metal electrode 19 and in electrically connecting the metal electrode 19 to the cable 17 becomes easy and reliable, which is also preferable to realize automation of work.

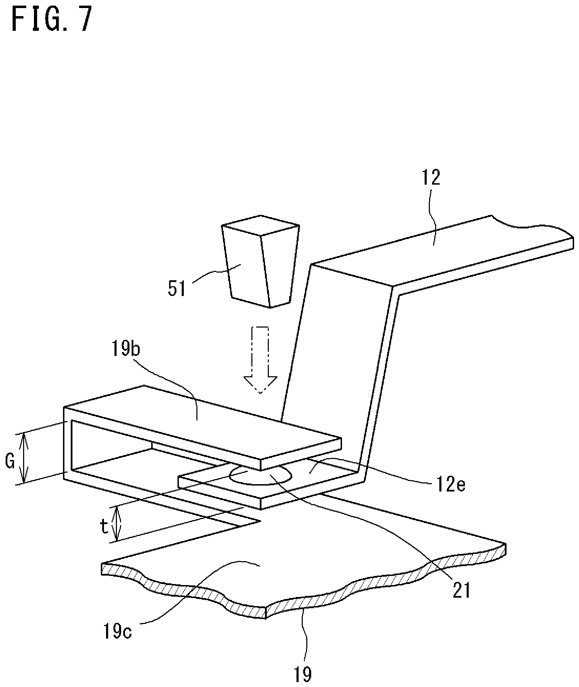

FIG. 7 to FIG. 9 are perspective views showing steps of joining the end portion 12e of the flexible printed circuit 12 to the metal electrode 19.

First, with reference to FIG. 7, a state before the end portion 12e of the flexible printed circuit 12 is brought to the predetermined position shown is considered. At this time, the joint portion 19b of the metal electrode 19 is ensured to have a predetermined gap G in a free and lone state, between the joint portion 19b and its opposed surface (i.e., the same plane as the base portion 19c), and has movability toward the opposed surface side when the joint portion 19b is pressed by the welder electrode 51 (or 52, the same applies to the following). The movability in this case is dependent on the elasticity of the joint portion 19b.

A thickness t (including the solder 21) of the end portion 12e having thereon the solder 21 in a solid state is smaller than the gap G (G>t). Thus, the end portion 12e (including the solder 21) having a smaller thickness than the dimension of the gap G can be easily inserted into the gap G, without raising the joint portion 19b. As shown in FIG. 5, when the end portion 12e is to be inserted into the gap G, the position where the end portion 12e is disposed under the joint portion 19b and the leading-end surface of the end portion 12e abuts against the protrusion 14a (FIG. 5) or is located slightly before the protrusion 14a is the predetermined position for the joining. That is, the protrusion 14a is helpful in positioning the end portion 12e at the time of insertion of the end portion 12e.

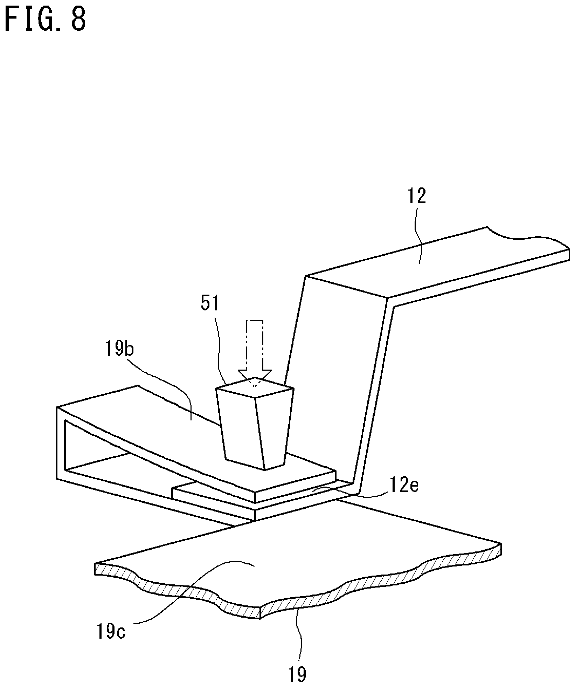

When the end portion 12e has been located at the predetermined position, the welder electrode 51 is subsequently lowered to press the joint portion 19b as shown in FIG. 8. At this time, the joint portion 19b flexes, thereby realizing a state where the joint portion 19b and the end portion 12e are strongly pressed to each other with the solder interposed therebetween. That is, a joint structure can be realized in which the joint portion 19b having elasticity flexes to be closely attached to the end portion 12e in a reliable manner.

Thus, it is possible to join the joint portion 19b and the end portion 12e to each other by performing local heating thereon in the state where the joint portion 19b and the end portion 12e (including the solder 21) are closely attached to each other with the welder electrode 51 pressed against the joint portion 19b.

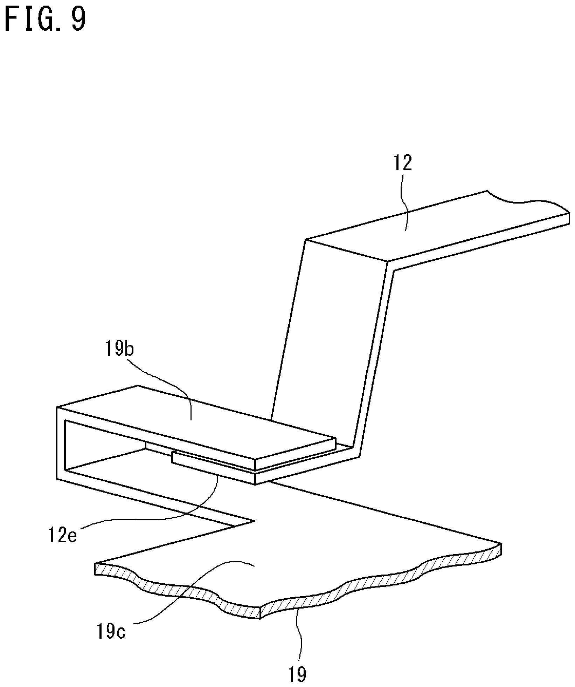

After completion of the welding, when the welder electrode 51 is withdrawn, the joint portion 19b returns to the original position due to its elasticity as shown in FIG. 9, but the joint portion 19b is in a state of being strongly joined to the end portion 12e.

The other joint portion 19b and the other end portion 12e can also be strongly joined together, in the same manner. Thus, two circuits in parallel can be connected to the cable 17 in the single junction box 14.

### «Summary (first embodiment)»

In the joint structure for the flexible printed circuit 12, the joint portion 19b of the metal electrode 19 in a free and lone state before being joined to the end portion 12e is ensured to have the gap G greater than the thickness of the end portion 12e, between the joint portion 19b and its opposed surface. Thanks to the presence of this gap G, without raising the joint portion 19b of the metal electrode 19, it is possible to easily insert the end portion 12e of the flexible printed circuit, between the joint portion 19b and its opposed surface.

According to the joint structure/joining method as described above, members for providing the joining can be easily and reliably arranged, and further, through the welding step, the joint portion and the end portion can be easily and quickly joined together. That is, the work in connecting the end portion of the flexible printed circuit to the external conductor becomes easy and reliable, which is also preferable to realize automation of work.

### «Second embodiment of joint structure/joining method»

Next, a second embodiment as the flexible-printed-circuit joint structure/joining method will be described.

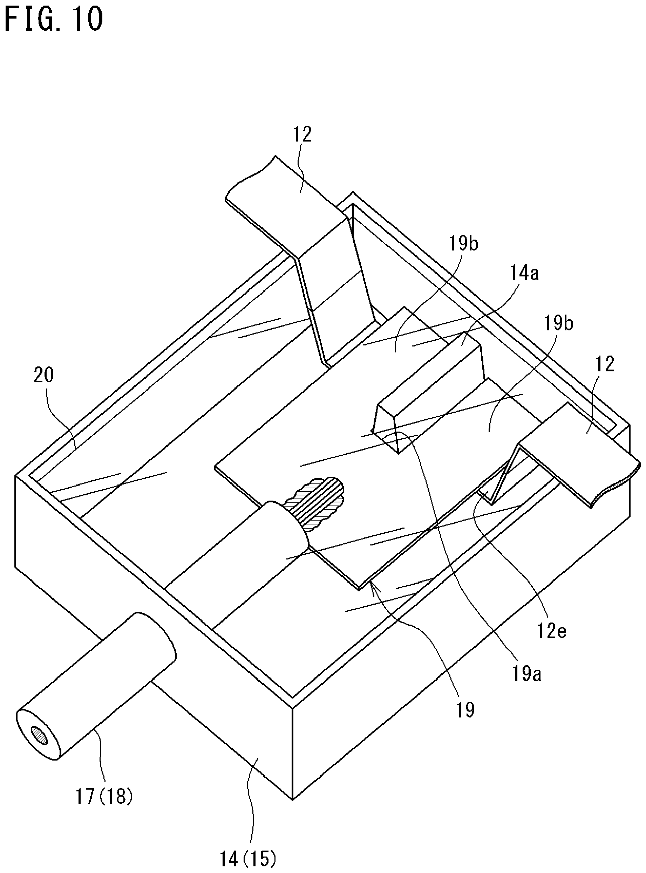

FIG. 10 is a perspective view showing the junction box 14 in its completed state. This junction box 14 is illustrated in a rectangular parallelepiped shape without a top face, but this is merely one example, and actually, the junction box 14 can be formed in various shapes as necessary. FIG. 10 merely shows one of the simple shapes, here. The junction box 14 is fixed to the bottom surface 11a of the housing 11, at a predetermined position (FIG. 4) on the rear surface side thereof. The other junction box 15 has the same structure, and thus, the junction box 14 will be described in detail as a representative example.

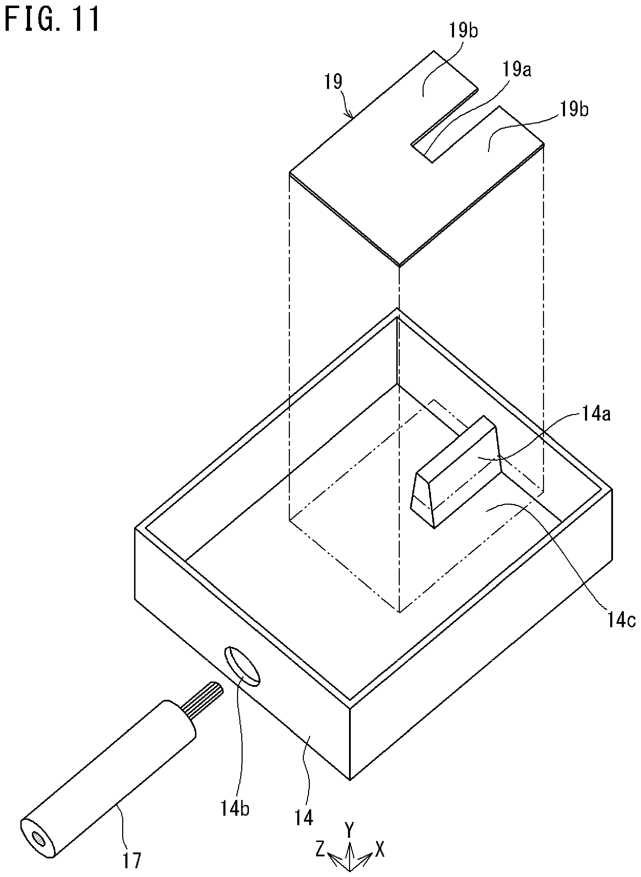

FIG. 11 is an exploded perspective view showing a part of the junction box 14 shown in FIG. 10.

In FIG. 11, the junction box 14 is a molded article made of heat resistant resin, for example. On the bottom surface of the junction box 14, the protrusion 14a for positioning is formed. For example, the width of the protrusion 14a in the Z direction in the drawing is decreased in accordance with increase in the height thereof in the Y direction (height direction) so as to facilitate mounting of the metal electrode 19. The hole 14b is formed in one side surface of the junction box 14, and the cable 17 can be passed through the hole 14b.

The recess 19a having a shape corresponding to the protrusion 14a is formed in the metal electrode 19 being an electric conductor (copper plate, for example). That is, while avoiding bumping into the protrusion 14a by means of the recess 19a, the metal electrode 19 can be guided to the protrusion 14a to be engaged therewith. However, the width (Z direction) of the recess 19a is slightly smaller than the width (Z direction) in a lower portion of the protrusion 14a. Accordingly, the lower surface of the metal electrode 19 is prevented from being entirely in contact with a bottom surface 14c of the junction box 14, and the metal electrode 19 is in a state of being slightly detached from the bottom surface. The dimension by which the metal electrode 19 is detached from the bottom surface serves similarly to the gap G in the first embodiment. The opposite sides of the recess 19a serve as the joint portions 19b which are to be joined with the end portions 12e of the flexible printed circuits 12, respectively.

With reference back to FIG. 10, the cable 17 is soldered to the metal electrode 19, for example. The end portion 12e of each flexible printed circuit 12 is disposed under its corresponding joint portion 19b, to be electrically and physically joined to the joint portion 19b. After completion of the joining, the junction box 14 is filled with the silicone resin 20, for example. The silicone resin 20 insulates and protects the metal electrode 19, the end portion 12e of each flexible printed circuit 12, and the mutual joining site of the cable 17, and fixes the entirety thereof. Since the junction box 14 is formed so as to be recessed relative to the bottom surface 11a of the housing 11, it is easy to flow the silicone resin into the junction box 14 after completion of the joining. The junction box 14 in this case is realized as a silicone resin molded frame.

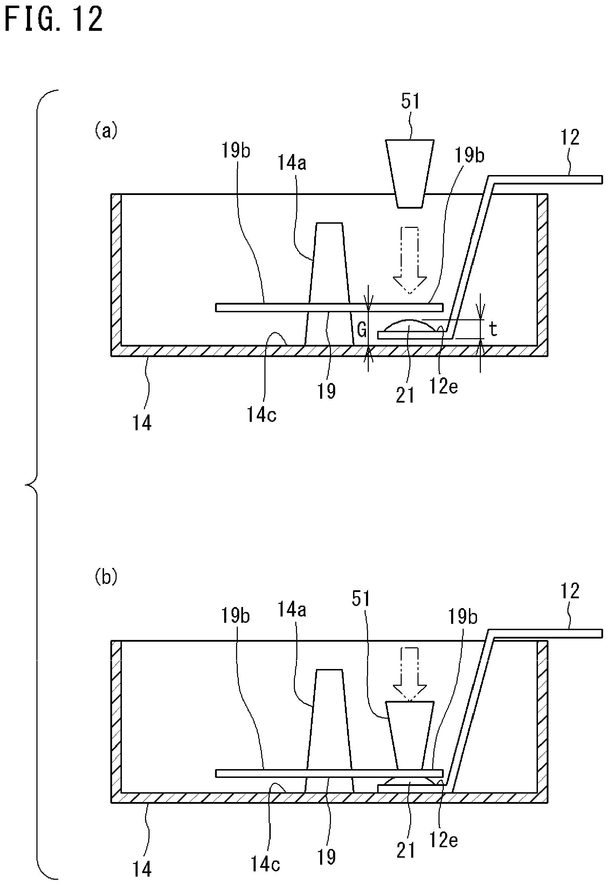

FIG. 12 to FIG. 13 are cross-sectional views showing steps of joining the end portion 12e of the flexible printed circuit 12 to the metal electrode 19 in the second embodiment.

First, in (a) of FIG. 12, a state before the end portion 12e of the flexible printed circuit 12 is brought to the predetermined position shown is considered. At this time, the joint portion 19b of the metal electrode 19 is ensured to have a predetermined gap G in a free and lone state, between the joint portion 19b and the bottom surface 14c being its opposed surface, and has movability toward the opposed surface side when the joint portion 19b is pressed by the welder electrode 51 (or 52, the same applies to the following). The movability in this case is dependent on elastic deformation of the metal electrode 19 that would widen the recess 19a, or elastic deformation of the joint portion 19b.

The thickness t (including the solder 21) of the end portion 12e having thereon the solder 21 in a solid state is smaller than the gap G (G>t). Thus, the end portion 12e (including the solder 21) having a smaller thickness than the dimension of the gap G can be easily inserted into the gap G, without raising the joint portion 19b. When the end portion 12e is to be inserted in the gap G, the position where the end portion 12e is disposed under the joint portion 19b and the leading-end surface of the end portion 12e abuts against the protrusion 14a or is located slightly before the protrusion 14a is the predetermined position for the joining. That is, the protrusion 14a is helpful in positioning the end portion 12e at the time of insertion of the end portion 12e.

When the end portion 12e has been located at the predetermined position, the welder electrode 51 is lowered to press the joint portion 19b as shown in (b) of FIG. 12. At this time, the joint portion 19b flexes in spite of the engagement with the protrusion 14a or the recess 19a (FIG. 11) is slightly widened, thereby realizing a state where the joint portion 19b and the end portion 12e are strongly pressed to each other with the solder 21 interposed therebetween.

Thus, it is possible to join the joint portion 19b and the end portion 12e to each other by performing local heating thereon in the state where the joint portion 19b and the end portion 12e (including the solder 21) are closely attached to each other with the welder electrode 51 pressed against the joint portion 19b.

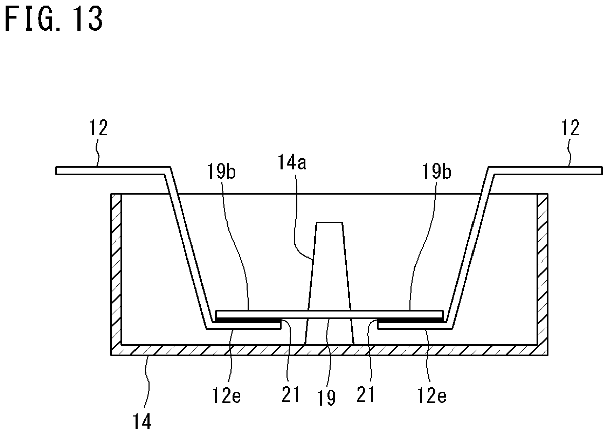

After completion of the welding, when the welder electrode 51 is withdrawn, the joint portion 19b is in a state of being strongly joined to the end portion 12e as shown in FIG. 13.

The other joint portion 19b and the other end portion 12e can also be strongly joined together, in the same manner.

### «Summary (second embodiment)»

In the joint structure for the flexible printed circuit 12, the joint portion 19b of the metal electrode 19 in a free and lone state before being joined to the end portion 12e is ensured to have the gap G greater than the thickness of the end portion 12e, between the joint portion 19b and its opposed surface (the bottom surface 14c). Thanks to the presence of this gap G, without raising the joint portion 19b of the metal electrode 19, it is possible to easily insert the end portion 12e of the flexible printed circuit, between the joint portion 19b and its opposed surface. Unlike the first embodiment, without employing a special shape of the metal electrode 19, it is possible to ensure the gap for inserting the end portion 12e by use of the engagement with the protrusion 14a.

According to the joint structure/joining method as described above, members for providing the joining can be easily and reliably arranged, and further, through the welding step, the joint portion and the end portion can be easily and quickly joined together. That is, the work in connecting the end portion of the flexible printed circuit to the external conductor becomes easy and reliable, which is also preferable to realize automation of work.

### «Others»

In the above embodiments, the description has been given of the joint structure/joining method for the flexible printed circuit 12 in the case where the module 1M is assumed as the targeted "apparatus". However, the joint structure/joining method themselves are not dependent on the concentrator photovoltaic module. Therefore, the joint structure/joining method can also be similarly applied to various types of electrical products, electrical equipment, wiring in automobiles which employ a flexible printed circuit, and the like.

It should be noted that the embodiments disclosed herein are merely illustrative in all aspects and should not be recognized as being restrictive. The scope of the present invention is defined by the scope of the claims, and is intended to include meaning equivalent to the scope of the claims and all modifications within the scope.

### REFERENCE SIGNS LIST

1 concentrator photovoltaic panel
1M concentrator photovoltaic module
3 pedestal
3a post
3b base
4 tracking sensor
5 pyrheliometer
11 housing
11a bottom surface
11b flange portion
12 flexible printed circuit
12e end portion
13 primary concentrating portion
13f Fresnel lens
14 junction box
14a protrusion
14b hole
14c bottom surface
15 junction box
16 power generating element
17, 18 cable
19 metal electrode
19a recess
19b joint portion
19c base portion
19d raised portion
19x copper foil
19y Sn plated layer
20 silicone resin
51, 52 welder electrode
100 concentrator photovoltaic apparatus

## Claims

1. A flexible-printed-circuit joint structure, comprising:
a junction box configured to connect an internal circuit of an apparatus and an external conductor to each other;
a metal electrode being in the junction box and to be joined to the external conductor; and
a flexible printed circuit in a strip shape, the flexible printed circuit forming the internal circuit and having an end portion to be joined to the metal electrode, wherein
the metal electrode has a joint portion to be joined to the end portion in a superposed manner, and the joint portion in a free and lone state before being superposed on the end portion is ensured to have a gap greater than a thickness of the end portion, between the joint portion and a surface opposed to the joint portion, and has movability toward the opposed surface side when the joint portion is pressed.

2. The flexible-printed-circuit joint structure according to claim 1, wherein
the joint portion is formed from a part of the metal electrode so as to have the gap, with a base portion except the part of the metal electrode assumed as the opposed surface.

3. The flexible-printed-circuit joint structure according to claim 2, wherein
the joint portion has elasticity that allows the joint portion to come close to the opposed surface.

4. The flexible-printed-circuit joint structure according to claim 1, wherein
a pair of the joint portions is provided in the metal electrode, a pair of the flexible printed circuits is present, and end portions of the pair of the flexible printed circuits are respectively joined to the pair of the joint portions.

5. The flexible-printed-circuit joint structure according to claim 4, wherein
the junction box has a protrusion formed therein, the metal electrode is engaged with the protrusion by means of a recess formed in a center portion of the metal electrode, and the end portions of the pair of the flexible printed circuits face the protrusion from opposite sides of the protrusion.

6. The flexible-printed-circuit joint structure according to claim 5, wherein
each joint portion in a free and lone state before being superposed on the end portion corresponding thereto is ensured to have the gap between the joint portion and the opposed surface, due to the engagement with the protrusion.

7. The flexible-printed-circuit joint structure according to claim 1, wherein
the junction box is provided on a bottom surface of the apparatus and is formed so as to be recessed relative to the bottom surface.

8. A concentrator photovoltaic module comprising:
a concentrating portion in which condenser lenses each converging sunlight are arranged in a matrix shape;
a housing configured to support the concentrating portion;
a flexible printed circuit arranged on a bottom surface of the housing;
power generating elements arranged on the flexible printed circuit so as to correspond to light-concentrating positions of the respective condenser lenses;
a junction box formed in a part of the bottom surface of the housing so as to be recessed relative to the bottom surface, the junction box having connected thereto an external conductor for collecting outputs of the power generating elements and for providing the collected outputs to outside;
a metal electrode being in the junction box and to be joined to the external conductor; and
a flexible printed circuit in a strip shape, the flexible printed circuit forming an internal circuit and having an end portion to be joined to the metal electrode, wherein
the metal electrode has a joint portion to be joined to the end portion in a superposed manner, and the joint portion in a free and lone state before being superposed on the end portion is ensured to have a gap greater than a thickness of the end portion, between the joint portion and a surface opposed to the joint portion, and has movability toward the opposed surface side when the joint portion is pressed.

9. The concentrator photovoltaic module according to claim 8, wherein
the flexible printed circuit is arranged so as to seamlessly continue on the bottom surface.

10. A flexible-printed-circuit joining method in which, in a junction box for connecting an internal circuit of an apparatus and an external conductor to each other, a metal electrode to be joined to the external conductor is connected to an end portion of a strip-shaped flexible printed circuit forming the internal circuit, the method comprising:
establishing a state in which a joint portion, of the metal electrode, to be joined to the end portion in a superposed manner is ensured to have a predetermined gap in a free and lone state of the joint portion, between the joint portion and a surface opposed to the joint portion, and has movability toward the opposed surface side when the joint portion is pressed;
inserting into the gap the end portion having a smaller thickness than a dimension of the gap; and
joining the joint portion and the end portion to each other by performing local heating thereon in a state where the joint portion and the end portion are closely attached to each other with a welder electrode pressed against the joint portion.
